# EUROPÄISCHE PATENTSCHRIFT

(11) **EP 0 612 410 B1**
(45) Veröffentlichungstag und Bekanntmachung des Hinweises auf die Patenterteilung: **31.03.1999**
(21) Anmeldenummer: 93918982.5
(22) Anmeldetag: 09.09.1993
(51) Int. Cl.: G01R 13/34

(54) **ABTASTVERFAHREN FÜR VERJITTERTE SIGNALE**
SCANNING PROCESS FOR JITTER SIGNALS
PROCEDE DE BALAYAGE POUR SIGNAUX DE GIGUE

(30) Priorität: 15.09.1992 DE 4230853
(43) Veröffentlichungstag der Anmeldung: 31.08.1994
(73) Patentinhaber: TEKTRONIX, INC., Wilsonville, Oregon 97070-1000 (US)
(72) Erfinder: VORWERK, Thomas, D-12355 Berlin (DE)
(74) Vertreter: Hofstetter, Alfons J., Dr.rer.nat.
(86) Internationale Anmeldenummer: DE9300845
(87) Internationale Veröffentlichungsnummer: WO9407148

(56) Entgegenhaltungen:
- EP-A- 0 234 883
- GB-A- 2 126 857
- GB-A- 2 128 858
- EDN ELECTRICAL DESIGN NEWS Bd. 34, Nr. 1 , 5. Januar 1989 , NEWTON, MASSACHUSETTS US Seiten 175 - 182 BLAIR ET AL. 'GLOSSARY TAKES THE MYSRERY OUT OF DSO TERMINOLOGY'
- INTERNATIONAL TEST CONFERENCE 1989 PROCEEDINGS; MEETING THE TESTS OF TIME 31. August 1989 , WASHINGTON, DC, USA Seiten 216 - 221 LAMAY ET AL. 'A TELECOMMUNICATIONS LINE INTERFACE TEST SYSTEM ARCHITECTURE'
- ELEKTRONIK Bd. 36, Nr. 5 , 6. März 1987 , MUNCHEN DE Seiten 130 - 132 KRAMER 'DER "MIXED SIGNAL"-TEST FÜHRT ZUM ZIEL'

## Beschreibung

Die Erfindung betrifft ein Verfahren zur Abtastung eines analogen, periodisch auftretenden Meßsignals.

Derartige Verfahren sind aus der europäischen Patentschrift EP-A-0 234 883 und aus der britischen Patentschrift GB-A-2 126 857 bekannt. In der britischen Patentschrift ist ein Verfahren zum Erfassen eines analogen, periodisch auftretenden Meßsignals mit Phasenjitter beschrieben, bei dem der Anfang jedes Meßsignals durch ein Triggersignal erfaßt wird und bei dem die Verzögerungszeit zwischen dem Auftreten des Triggersignals und dem Zeitpunkt der jeweiligen Meßwertaufnahme dem jeweils aufgenommenen Meßwert zugeordnet gespeichert wird. In der europäischen Patentschrift ist ein Verfahren beschrieben, mit dem Abtastwerte eines periodischen Signals nicht in einem festen zeitlichen Raster, wie bei dem Verfahren gemäß der britischen Patentschrift, sondern zeitlich kontinuierlich aufgenommen werden; hierzu wird ein Pseudo-Random-Generator eingesetzt, der die Abtastzeitpunkte (zeitlich) zufällig verteilt.

In der ISDN-Meßtechnik werden Messungen an der sogenannten S0-Schnittstelle durchgeführt. Eine dieser Messungen besteht aus der Analyse bestimmter periodischer Meßsignale in Form von Impulsen an dieser Schnittstelle. Das Meßsignal wird in einem sogenannten ISDN-Endgerät digital erzeugt und ist mit einem Phasenjitter behaftet, der dem Betrag nach wesentlich größer ist als die geforderte Meßwertauflösung.

Gemäß der FTZ 1 TR 230/CCITT-Empfehlung soll das Meßsignal mit einem Vorereignis von 2,5 µs und einem ebenso großen Nachlauf erfaßt werden. Hierdurch ist eine direkte Triggerung auf das zu erfassende Meßsignal nicht mehr möglich.

Der Erfindung liegt die Aufgabe zugrunde, ein Verfahren zum Erfassen eines analogen, periodisch auftretenden Meßsignals mit Phasenjitter unter Berücksichtigung eines Vorereignisses anzugeben.

Diese Aufgabe wird erfindungsgemäß durch die im Patentanspruch angegebenen Merkmale gelöst.

Im folgenden wird die Erfindung anhand eines in der Zeichnung dargestellten Ausführungsbeispieles beschrieben. Dabei zeigen
- Fig. 1: ein Blockschaltbild einer Schaltungsanordnung zur Durchführung des erfindungsgemäßen Verfahrens, und
- Fig. 2: ein Impulsdiagramm zur Erläuterung.

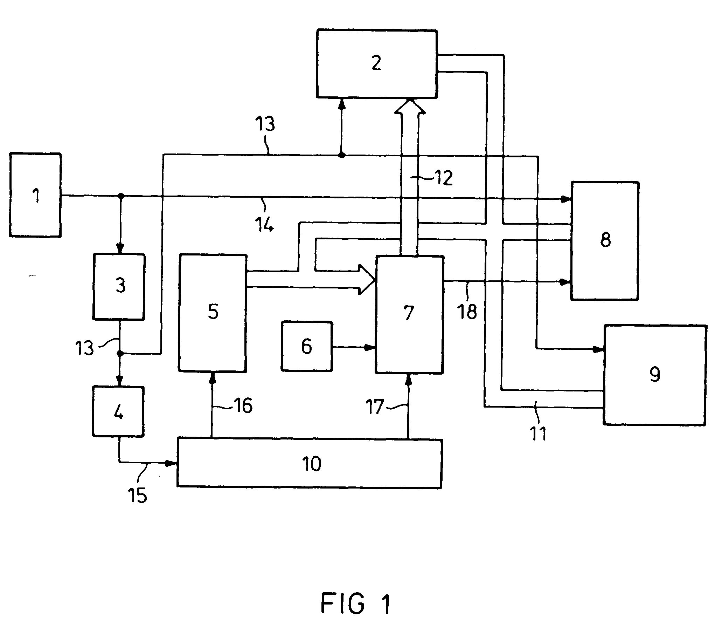

In der Fig. 1 sind die für das Verständnis der Erfindung notwendigen Schaltungsteile und Verbindungen dargestellt.

Dies sind im einzelnen eine Schnittstelleneinrichtung 1, die ein periodisch auftretendes Meßsignal über eine Leitung 14 an einen Komparator 3 und einen Digitalisierungsbaustein 8 mit Abtast- und Haltestufe und nachgeschaltetem AD-Wandler gibt. Der Komparator 3 gibt ein Triggersignal über eine Leitung 13 an eine PLL-Stufe 4, an einen Latchbaustein 2 und an einen Microprozessor 9. Die PLL-Stufe legt einen Meßsignalwiederholtakt über eine Leitung 15 an eine Ablaufsteuerung 10.

Die Ablaufsteuerung 10 steuert über eine Steuerleitung 16 einen Meßpunktzähler 5 und über eine Steuerleitung 17 einen Verzögerungszähler 7 an, dessen Zählrate durch einen angeschalteten Taktgenerator 6 bestimmt ist.

Der Ausgang für den Zählerstand des Meßpunktzählers 5 liegt über einen Datenbus 11 am Eingang des Verzögerungszählers 7 an. Mit dem Datenbus 11 sind auch die entsprechenden Ausgänge des Latchbausteins 2, des Digitalisierungsbausteines 8, und die Datenbusanschlüsse des Microprozessors 9 verbunden. Die Ausgänge für den Zählerstand des Verzögerungszählers 7 liegen über eine Datenleitung 12 an den Eingängen des Latchbausteins 2 an.

Der Verzögerungszähler 7 gibt einen Triggerpuls über eine Leitung 18 an den Digitalsierungsbaustein 8.

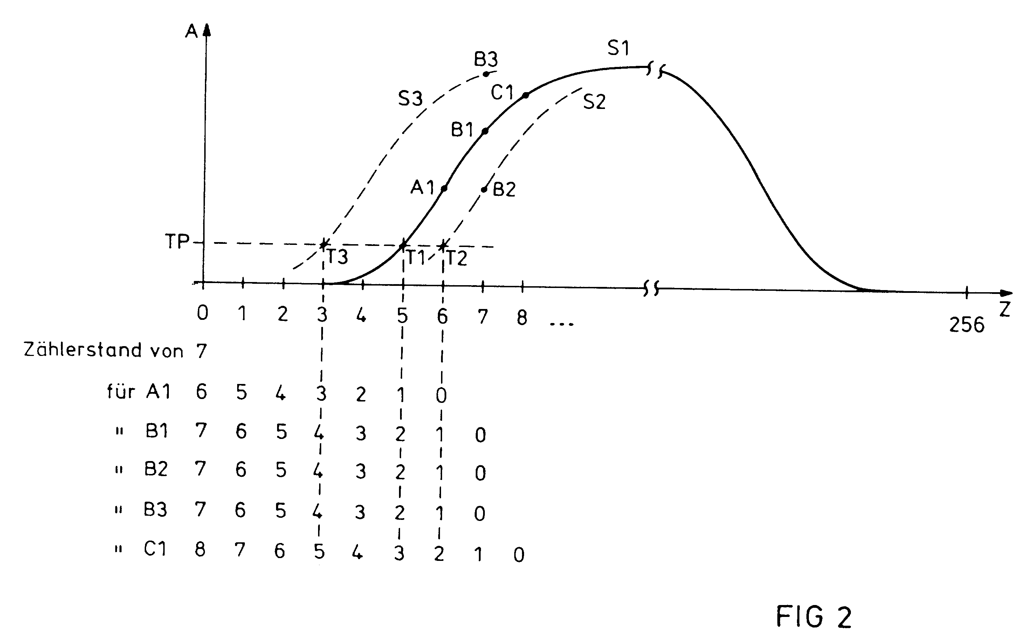

In Fig. 2 ist eine Amplitude A eines als jitterfrei angenommenen Meßsignals S1 gegen ein Zeitraster dargestellt. Das Zeitraster wird hierbei durch Meßzeitpunkte Z mit den Werten von 0 - 256 gebildet, wobei die Anzahl und der zeitliche Abstand der Meßzeitpunkte Z durch die Dauer des Meßsignals S1 inklusive Vorereignis und Nachlauf und die vorgegebene Auflösung bestimmt sind.

Weiter sind verjitterte Meßsignale S2 und S3 dargestellt, wobei das Meßsignals S2 in seiner Phase gegenüber dem Meßsignal S1 nacheilt, und das Meßsignals S3 in seiner Phase gegenüber dem Meßsignal S1 voreilt. Dabei ist ferner bei den weiteren Erläuterungen davon ausgegangen, daß auf ein Meßsignal S1 mit dem Meßpunkt A1 entweder das Meßsignal S2 oder das Meßsignal S3 als nächstes folgt. Das Meßsignal S1 weist den Meßpunkt A1 und die Meßsignale S2 und S3 jeweils einen Meßpunkt B2 bzw. B3 auf.

Ein in seiner Amplitude vorgegebener Triggerpegel TP sowie seine Triggerpunkte T1 bis T3, d. h. seine Schnittpunkte mit den Meßsignalen S1 bis S3 sind eingezeichnet.

Bei der folgenden Beschreibung der Erfindung wird auf die Figuren 1 und 2 Bezug genommen.

Die Meßsignale S1 bis S3 werden durch ein sogenanntes Sampling-Verfahren abgetastet. Die Meßsignale S1 bis S3 werden von der Schnittstelleneinrichtung 1 auf der Leitung 14 an den Digitalisierungsbaustein 8 gegeben. Dieser Digitalisierungsbaustein 8 enthält eine Abtast- und Haltestufe sowie einen nachgeschalteten AD-Wandler (beide nicht näher dargestellt) zur Digitalisierung der anliegenden Signale.

Die Meßsignale S1 bis S3 liegen am Komparator 3 an, der bei Überschreitung des Triggerpegels TP durch die Meßsignale S1 bis S3 jeweils ein Triggersignal auf der Leitung 13 abgibt.

Die Leitung 13 liegt an der PLL-Stufe 4 an, die aufgrund der periodisch auftretenden Meßsignale S1 bis S3 aus dem Triggersignal einen Meßsignalwiederholtakt bildet und über die Leitung 15 an die Ablaufsteuerung 10 gibt. Die Phase des Meßsignalwiederholtaktes eilt den zu erfassenden Meßsignalen S1 bis S3 um die Dauer des gewünschten Vorereignisses voraus.

Das erfindungsgemäße Verfahren funktioniert auch ohne die PLL-Stufe 4, wenn der Systemgrundtakt bekannt ist. Dann ist noch für eine korrekte Phasenlage dieses Grundtaktes zu sorgen, damit das geforderte Vorereignis mit erfaßt werden kann. Hierzu kann ein Phasenschieber verwendet werden.

In an sich bekannter Weise wird jedem periodisch auftretenden Meßsignal ein Meßwert entnommen. Nach jedem aufgenommenen Meßwert wird die Aufnahme des folgenden Meßwertes aus dem nachfolgend auftretenden Meßsignal um eine der Auflösung entsprechende Zeiteinheit verzögert. Hierdurch wird nach und nach das gesamte periodisch auftretende Meßsignal abgetastet. Unter Meßwert ist hierbei der digitalisierte Wert eines Meßsignales S1 bis S3 zu einem der Meßzeitpunke Z des Zeitrasters zu verstehen.

Die erforderliche Verzögerung zur Aufnahme des Meßwertes des jeweils nachfolgenden einzelnen Meßsignals wird durch den Verzögerungszähler 7 realisiert, der nach jedem aufgenommenen Meßpunkt die Anzahl der bisher aufgenommenen Meßpunkte aus dem Meßpunktzähler 5 lädt. Der Zahlerstand des Meßpunktzahlers 5 wird nach der Aufnahme jedes Meßpunktes um den Wert 1 erhöht. Die ständig wachsende Verzögerung und damit die Aufnahme des jeweils nachfolgenden Meßpunktes ergibt sich durch Rückwärtszählung des Verzögerungszählers 7.

Bei Erreichen des Zählerstandes Null (rückwärtiger Überlauf) wird vom Verzögerungszähler 7 über die Leitung 18 ein Triggerpuls an den Digitalisierungsbaustein 8 gegeben, der zu diesem Meßzeitpunkt Z den Wert des anliegenden Meßsignals digitalisiert und den digitalisierten Wert an den Datenbus 11 abgibt.

Das Starten des Verzögerungszählers 7 wird stets durch den von der PLL-Stufe 4 abgegebenen phasenstarren Meßsignalwiederholtakt auf der Leitung 15 über die Ablaufsteuerung 10 ausgelöst. Die Aufnahme eines nachfolgenden Meßpunktes wird dabei um die Verzögerungszeit, beispielsweise 42 ns, vergrößert. Der Verzögerungszähler 7 wird vom Taktgenerator 6 mit der Zeiteinheit von beispielsweise 42 ns getaktet. Durch den Taktgenerator 6 ist die Auflösung der Meßkurvenaufnahme, d.h. die zeitlichen Abstände zwischen den aufeinanderfolgenden Meßpunkten bestimmt.

Erfindungsgemäß wird die Triggerung durch das eigentliche Meßsignal benutzt, um zu diesem Zeitpunkt den Zählerstand des Verzögerungszählers 7 und damit die zeitliche Lage des jeweiligen Meßsignals zu erfassen. Bei der Aufnahme jedes Meßpunktes zu den Meßzeitpunkten Z wird der Zeitpunkt des Triggerpunktes T1 (bzw. T2 und T3) des Meßsignals S1 (bzw. S2 und S3) innerhalb des Zeitrasters erfaßt.

Bei der nachfolgenden Beschreibung wird insbesondere auf die in Fig. 2 dargestellte Tabelle Bezug genommen, in der für Meßpunkte A1, B1, B2, B3 und C1 der Zahlerstand des Verzögerungszählers 7 in Abhängigkeit von den Meßzeitpunkten Z aufgetragen ist.

Der Zählerstand des Verzögerungszählers 7 wird zu jedem der Meßzeitpunkte Z um den Wert 1 erniedrigt, bis bei dem Wert Null die Digitalisierung durch den Digitalisierungsbaustein 8 erfolgt.

Bei der Aufnahme des Meßwertes A1 des Meßsignals S1 wird in den Verzögerungszähler 7 der vom Meßpunktzahler 5 abgegebene Zählerstand mit dem Wert 6 geladen, weil es sich um den Meßpunkt 6 handelt, wobei mit dem ersten Meßpunkt mit dem Wert Null im Meßpunktzähe 5 begonnen wurde. Der Zählerstand wird beispielsweise über den Datenbus 11 übertragen. Es kann auch eine zusätzliche Verbindung vorgesehen sein.

Ferner wird der Signalanfang des Meßsignals S1 erfaßt. Dazu wird der Triggerpunkt T1, bei dem die Amplitude A des Meßsignals S1 den Triggerpegel TP überschreitet, im Komparator 3 festgestellt. Der Komparator 3 gibt das Triggersignal über die Leitung 13 ab, wodurch der Zählerstand (in diesem Fall der Wert 1) des Verzögerungszählers 7 zu diesem Zeitpunkt in den Latchbaustein 2 übernommen wird. Das Triggersignal liegt auch am Microprozessor 9 an, so daß dieser Zahlerstand, der dem Zeitpunkt des Signalanfangs im Zeitraster der Meßzeitpunkte Z entspricht, zusammen mit dem anschließend aufgenommenen Meßwert des Meßpunktes Al abespeichert werden kann.

Bei der Aufnahmne des nachfolgenden Meßpunktes B1 eines nachfolgenden weiteren unverjitterten Meßsignals S1 wird in den Verzögerungszähler 7 der Zahlenwert 7 geladen. Beim Wert Null im Verzögerungszähler 7 erfolgt wiederum die Meßwertaufnahme durch den Digitalisierungsbaustein 8. Beim Triggerpunkt T1 dieses weiteren Meßsignals S1 wird der Wert 2 in den Latchbaustein 2 übernommen.

Bei der Aufnahme des nachfolgenden Meßpunktes C1 eines nachfolgenden zusätzlichen unverjitterten Meßsignals S1 wird in den Verzögerungszähler 7 der Zahlenwert 8 geladen. Beim Wert Null im Verzögerungszähler 7 erfolgt die Meßwertaufnahme durch den Digitalisierungsbaustein 8. Beim Triggerpunkt T1 wird der Wert 3 in den Latchbaustein 2 übernommen.

Die Meßpunkte Al, B1 und C1 liegen auf als jitterfrei angenommenen Meßsignalen S1. Die Meßpunkte B2 und B3 liegen auf den mit einem Phasenjitter behafteten Meßsignalen S2 und S3.

Bei der Aufnahme des Meßpunktes B2 eines anstelle des weiteren unverjitterten Meßsignals S1 auftretenden verjitterten Signals S2 wird in den Verzögerungszähler 7 der Zahlenwert 7 geladen.

Beim Wert Null im Verzögerungszähler 7 erfolgt die Meßwertaufnahme. Das Meßsignal S2 hat den Triggerpunkt T2, bei dem der Wert 1 aus dem Verzögerungszähler 7 in den Latchbaustein 2 übernommen wird.

Bei der Aufnahme des Meßpunktes B3 eines anstelle des weiteren unverjitterten Meßsignals S1 auftretenden verjitterten Meßsignals S3 wird in den Verzögerungszähler 7 der Zahlenwert 7 geladen. Beim Wert Null im Verzögerungszähler 7 erfolgt wiederum die Meßwertaufnahme. Das Meßsignal S3 hat den Triggerpunkt T3, bei dem der Wert 4 in den Latchbaustein 2 übernommen wird.

Der Meßpunkt B2 des Meßsignals S2 entspricht dem Zeitpunkt seiner Meßwertaufnahme nach auf der Zeitachse dem Meßpunkt B1 des Meßsignals S1. Durch den mitabgespeicherten "Zeitwert" für den zugehörigen Signalanfang, d.h. den Triggerpunkt T1 bzw. T2, ist eine nachträgliche Umsortierung der Meßwerte möglich. Analoges gilt für den Meßpunkt B3 des Meßsignals S3.

Bei verjitterten Meßsignalen werden bei einem Durchlauf wahrscheinlich nicht alle zum Zeitraster gehörenden Meßpunkte erfaßt, da durch den pro Meßpunkt unterschiedlich starken Jitter einige Meßpunkte mehrmals erfaßt und andere ausgelassen werden. Dies kann durch die Mitteilung über mehrere Meßzyklen ausgeglichen werden.

## Patentansprüche

1. Verfahren zum Erfassen eines analogen, periodisch auftretenden Meßsignals (S1 bis S3) mit Phasenjitter, bei dem pro Einzelsignal ein Meßwert aufgenommen wird und jede nachfolgende Meßwertaufnahme um eine Zeiteinheit verzögert erfolgt, bei dem
- ein Meßpunktzähler (5) zu einem durch den Beginn eines zu erfassenden Vorereignisses des Meßsignals (S1 bis S3) vorgegebenen Zeitpunkt auf den Zählerstand Null gesetzt wird,
- der Anfang jedes Meßsignals (S1 bis S3) durch ein Triggersignal erfaßt wird,
- nach jeder Aufnahme eines Meßpunktes der Meßpunktzähler (5) in seinem Zählerstand um Eins erhöht wird,
- der jeweils neue Zählerstand des Meßpunktzählers (5) in einen rückwärts zählenden Verzögerungszähler (7) übertragen wird,
- der durch einen aus dem Meßsignal gewonnenen Meßsignalwiederholtakt gestartet wird und
- der die Impulse eines Taktgenerators (6) rückwärts zählend erfaßt,
- während des Rückzählens des Verzögerungszählers (7) jeweils derjenige Zählerstand festgehalten wird, bei dem das Triggersignal erzeugt wird,
- jeweils beim Zählerstand Null des Verzögerungszählers (7) eine Meßwertaufnahme veranlaßt wird und
- der jeweils festgehaltene Zählerstand des Verzögerungszählers (7) dem jeweils aufgenommenen Meßwert zugeordnet gespeichert wird.

## Claims

1. A process for scanning an analog, periodically appearing measuring signal (S1 to S3) with phase jitter, wherein one measured value is taken per individual signal and each subsequent taking of a measured value will be delayed by one time unit, wherein
- a measuring point counter (5) will be set to a count zero at a time predetermined by the start of a previous event, to be scanned, of the measuring signal (S1 to S3),
- the beginning of each measuring signal (S1 to S3) will be detected by a trigger signal,
- after each taking of a measuring point, the count of the measuring point counter (5) will be incremented by one,
- the respective new count of the measuring point counter (5) will be transferred to a counting-down delay counter (7),
- which is started by a measuring signal repeat clock obtained from the measuring signal and
- which detects the pulses of a clock generator (6) in a counting-down manner,
- during the counting-down process of the delay counter (7) the very count will be held at which the trigger signal is generated,
- each count zero of the delay counter (7) will cause a measured value to be taken, and
- the held count of the delay counter (7) in each case will be stored associated to the measured value taken.

## Revendications

1. Procédé pour échantillonner un signal de mesure (S1 à S3) de gigue analogique apparaissant périodiquement, pour lequel une valeur de mesure est enregistrée à chaque signal et chaque enregistrement suivant est retardé d'une unité de temps, pour lequel
- un compteur de points de mesure (5) est remis à zéro à un instant déterminé par le début d'un événement précédant le signal de mesure (S1 à S3),
- le début de chaque signal de mesure (S1 à S3) est saisi par un signal de déclenchement,
- le compteur de points de mesure (5) est augmenté de la valeur 1 après chaque enregistrement d'un point de mesure,
- chaque nouvelle indication du compteur de points de mesure (5) est transférée vers un compteur de retard (7) comptant à rebours,
- qui est activé par un rythme de répétition de signal tiré du signal de mesure
- qui compte à rebours les impulsions du générateur de rythme (6)
- lors du compte à rebours du compteur de retard (7), chaque indication du compteur est retenue, pour laquelle le signal de déclenchement est créé,
- un enregistrement de valeur de mesure est effectué à chaque indication du compteur de retard (7) égale à zéro et
- chaque indication du compteur de retard (7) retenue est mémorisée en tant qu'attribut à la valeur de mesure correspondante enregistrée.
